# EUROPEAN PATENT APPLICATION

(11) **EP 2 851 946 A1**
(43) Date of publication of application: **25.03.2015**
(21) Application number: 13185143.8
(22) Date of filing: 19.09.2013
(51) Int. Cl.: H01L 23/31, H01L 23/495, H01L 23/00

(54) **Surge protection device**

(71) Applicant: NXP B.V., 5656 AG Eindhoven (NL)
(72) Inventor: Holland, Steffen, Redhil, Surrey RH1 1NY (GB); Boettcher, Tim, Redhill, Surrey RH1 1NY (GB)
(74) Representative: Crawford, Andrew

(57) **Abstract**

A surge protection device (30) for improved heat dissipation which comprises; a lead frame (32); a semiconductor substrate (40) formed of a first conductivity type and mounted on said lead frame, said semiconductor substrate comprising first and second opposing surfaces, said second surface having a region of second conductivity type, wherein said region of second conductivity type comprises an electrical contact (38) for contactably mounting said substrate to said lead frame; and an insulation layer (31) disposed at the second surface and arranged to insulate the region of first conductivity type from the lead frame.

## Description

### FIELD

The present invention relates to surge protection device.

### BACKGROUND

Electrical surges such as electrical overstress or electrostatic discharge transient pulses are common causes of damage to electronic devices. To protect against such transient surges electronic devices are conventionally protected by surge protection devices. One type of protection device is the so called Transient voltage suppression (TVS) device.

TVS devices provide protection against electrical overstress or electrostatic discharges and are commonly used in portable/consumer electronic devices such as personal computers, audio and video equipment or mobile telephones. According to the International Electrotechnical Commission standards IEC 61643-321 and IEC 61000-4-5 such devices are designed to protect against 10/1000µs pulses and 8/20 µs pulses (where the quoted 10 and 8 µs are the transient rise time and the 1000 and 20 µs is the time to half of the peak value). These devices require special clip packages such as clips attached to the top of the device using Pb-rich soft solders to make the electrical connection. Typically devices are rated to cope with 400W, 600 or 1000 Watts of power.

Such devices can be typically formed of a vertically arranged pn-junction device formed on silicon substrate with soft soldered electrical connections on the front and back side of the junction. This allows the device to withstand the specified surge pulse due to thermal dissipation on both sides of the pn-junction device such that the junction temperature increase is limited.

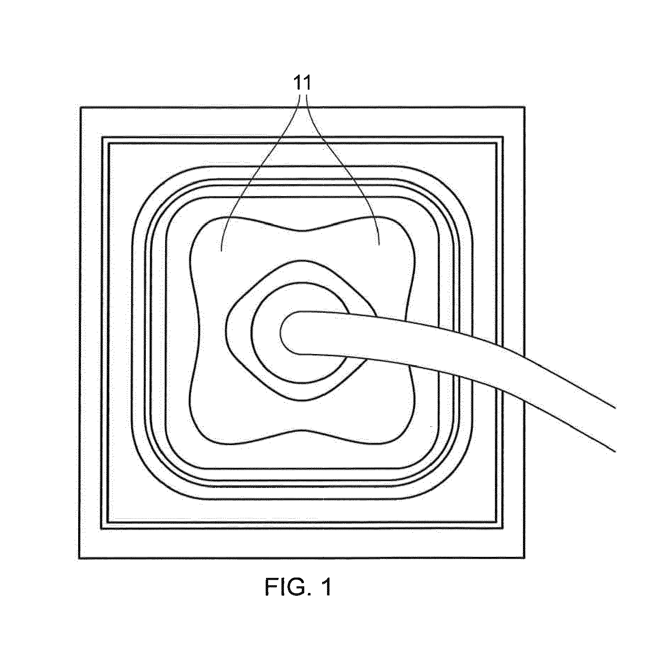

Wire bonded surge protection diodes such as the type shown in Figure 1 have the pn junction active area (not visible) arranged towards the top of the device and a first contact to either the p or n side (as the case may be) of the junction is made by way of a wire bond 10 attached to the top of device. The lead frame (not visible) for such a device will be on the underside and provides the second contact to the junction. In semiconductor devices, lead frames are generally formed of metallic materials and thus provide a route for heat dissipation during operation of the device. As a result of the active area being separated from the lead frame, heat generated in the active area during operation cannot easily be dissipated away from the pn-junction to the lead frame resulting in hot-spots within the device crystal which can lead to heat damage 11 induced failure of the device as indicated in Figure 1. This limits thermal performance resulting in reduced stability under reverse current transient pulses.

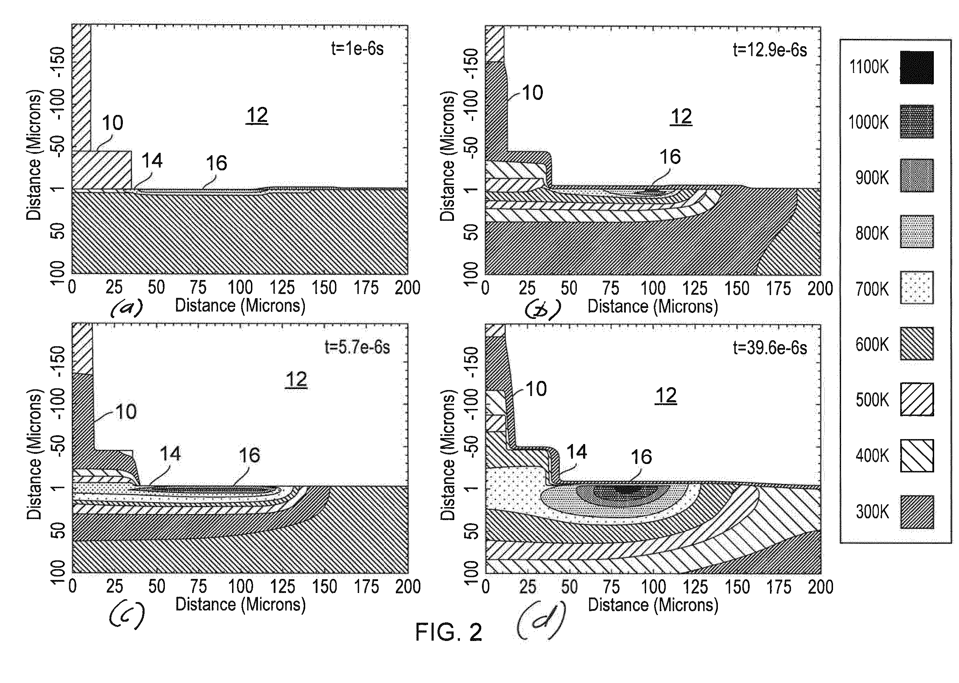

Figures 2a to 2d show the heat dissipation profile over time for an exemplary prior art device. The wire bond 10 to the device is connected to the active area 14. During operation from time t=1 us to t=39.6us the device can be seen to heat up with the hot spot 16 shown outside the area of wire bond under the mould compound 12. Due to the conductive nature of the wire bond heat generated in the active area 14 will dissipated through the wire bond. As a result, hot spots will generally occur away from the wire bond under the mould compound. Typically this can be due to the insufficient heat dissipation capability of the mold compound. The resulting hot spot can cause the device material to melt resulting in failure of the device, for example as discussed above in relation to Figure 1.

The present invention seeks to provide a surge protection device which is not prone to overheating device failure.

### SUMMARY

There is provided a surge protection device comprising: a lead frame; a semiconductor substrate formed of a first conductivity type and mounted on said lead frame, said semiconductor substrate comprising first and second opposing surfaces, said second surface having a region of second conductivity type, wherein said region of second conductivity type comprises an electrical contact for contactably mounting said substrate to said lead frame; and an insulation layer disposed at the second surface and arranged to insulate the region of first conductivity type from the lead frame.

As a result the surge protection device provides for improved heat dissipation through the lead frame, thus preventing device failure due to hot spots.

An insulation layer is arranged to prevent electrical contact between the lead frame and the first conductivity type of the semiconductor substrate. The insulation layer may be a passivation layer. The lead frame may comprise a raised portion for contacting to the electrical contact.

Therefore the leakage currents and shorts circuits which may arise due to the proximity of the active area to the lead frame are reduced.

### DESCRIPTION OF THE DRAWINGS

Throughout the following discussion like reference numerals refer to like features. The invention will now described further hereinafter by way of example only with reference to the accompanying drawings in which:
Figure 1 illustrates the top of a wire bonded surge protection device according to the prior art;
Figures 2a to 2d are heat distribution images over time for a wire bonded surge protection device according to the prior art;
Figures 3a shows a pn junction device having a eutectic die attach material mounted on a leadframe with a raised portion formed on the lead frame;
Figure 3b shows a pn junction device having a solder die attach material mounted on a leadframe with a raised portion formed on the lead frame;
Figure 4a shows a pn junction device having a eutectic die attach material mounted on a leadframe with a raised portion formed on the lead frame;
Figures 4b shows a pn junction device having a solder die attach material mounted on a leadframe with a raised portion formed on the lead frame;
Figure 5a shows a pn junction device with side wall passivation in a two- step wafer cut having a glue attach material and mounted on a substantially planar leadframe;
Figure 5b shows a pn junction device with side wall passivation having a glue attach material and mounted on a substantially planar leadframe;
Figure 6 shows a pn junction device with trench passivation having a glue attach material and mounted on a substantially planar leadframe;
Figure 7 shows a pn junction device with mesa passivation having a glue attach material and mounted on a substantially planar leadframe;
Figure 8a shows a pn junction device having a solder bump attach material and mounted on a substantially planar leadframe;
Figure 8b shows a pn junction device having a eutectic die attach material and mounted on a substantially planar leadframe; and
Figure 9 heat distribution image for bonded surge protection device in accordance with embodiments 8b.

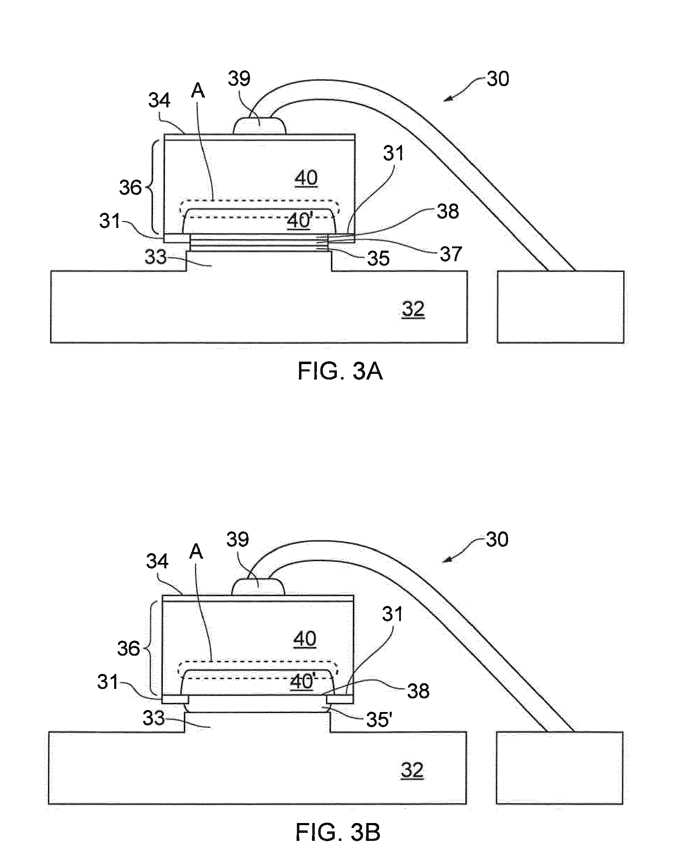

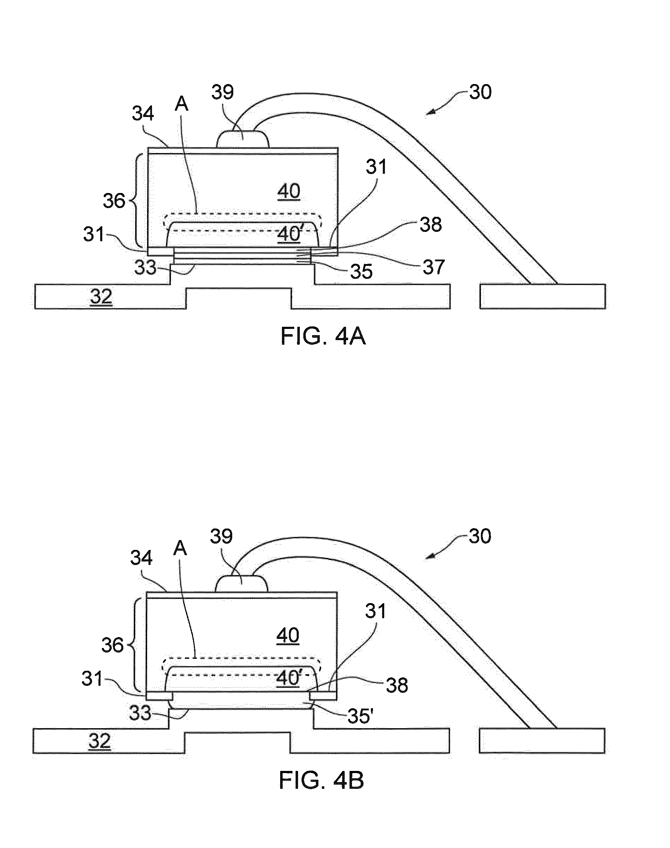

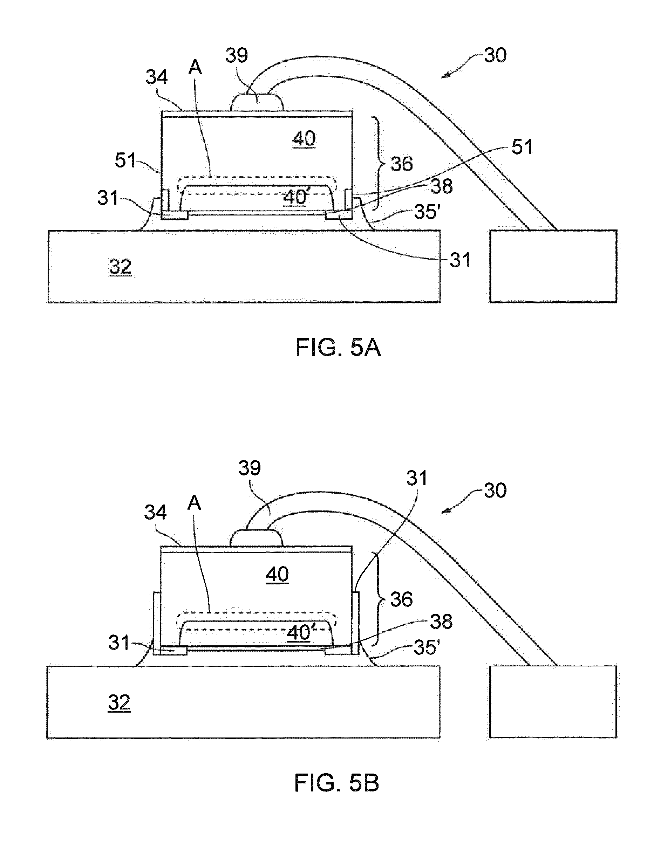

Referring now to Figures 3a and 3b, a surge protection device 30 comprises a p-n junction 36 mounted on a lead frame 32. The p-n junction may be formed on an n-type conductivity silicon substrate 40 having a p-type conductivity impurity region 40' formed in the n-type substrate 40. The skilled person will recognise that the p-type impurity region 40' can be formed in the n-type substrate 40 by any appropriate means, for example diffusion or implantation. The p-n junction structure illustrated in Figures 3a and 3b (and also Figures 4a, 4b, 5a and 5b discussed in more detail below) may be considered a planar structure. Furthermore, in the examples discussed herein, reference will be made to p-type conductivity regions and n-type conductivity substrates. However, the skilled person will recognise that the opposite conductivity types may also hold true, that is, n-type conductivity regions may be formed on p-type substrates. Electrical bonds may be made to respective metallic contacts, also known in the art as contact metal, to the p-type and n-type conductivity regions forming the pn-junction 36. A first metallic contact 34 is made on a first surface of the pn-junction 36 formed by the n-type substrate. A second metallic contact 38 is formed on a second surface of the pn-junction forming a p-type impurity region. The first and second surfaces are opposed as therefore are the first 34 and second 38 metallic contacts. The first 34 and second 38 metallic contacts may be formed on the respective opposing first and second surfaces of the device 30. The formation of the metallic contacts will not be discussed in detail herein, however the skilled person will appreciate that they may be formed of any suitable material, for example Cu, and formed by any suitable process, for example sputtering.

The lead frame may comprise a raised or "MESA" type portion 33 for mounting the pn-junction thereon 36. The p-n junction 36 is mounted and electrically connected on the raised portion 33 via the second contact 38 to the p-type impurity region, such that the active area formed at the junction of the p- and n-type materials is closer to the lead frame than it is to the first metallic contact 34 formed at the n-type substrate material.

Referring to Figure 3a, the electrical connection between second contact 38 to the p-type impurity region of the pn junction 36 and the lead frame raised portion 33 may be made by any suitable eutectic die attach material 35 such as for example alloys of Au. A diffusion barrier 37 may be included between the second contact 38 and the die attach material 35. The diffusion barrier 37 is provided to prevent out diffusion of the contact metal into the die attach material 35 and/or lead frame 32 material, which may result in failure of the contact 38.

Referring to Figure 3b the semiconductor device 30 is connected to the lead frame using for example, solder based attachment materials 35, 35'. Alternatively, conductive glues, conducting wafer back coatings or conducting films may be used in place of solder.

The lead frame 32 may be formed of any appropriate material, such as for example high thermal conductivity materials such as Cu. The lead frame raised portion 33 may be smaller in width than the width of the p-n junction 36. Therefore any excess die attach material that may spill over during the die attach process may fall to the sides of the lead frame at either side of the raised portion 33 of the lead frame 32.

With reference to Figures 3a and 3b, a passivation layer 31 may at provided the second surface of the pn-junction such that it partially covers the second surface. The skilled person will recognise that the passivation layer only partially covers the second surface due to the need for the contact metal applied to the p-type material. Due the close proximity of the active pn-junction region A to the leadframe 32, the passivation layer 31 may provide an isolation layer between the n-type substrate material and the lead frame 32. In the context of semiconductor devices the skilled person will understand the active region to be the interface of n- and p-type conductivity types.

The proximal nature of the active pn-junction region A to the lead frame provides an efficient heat sink for heat generated in the active region into the lead frame. The passivation layer 31 may prevent short circuiting of the n-type substrate with the lead frame 32, caused by for example excessive die attach, solder materials that may fall on to the lead frame 32 and connect to the n-type substrate.

The passivation layer 31 may also prevent leakage currents shorting the n-type substrate to the lead frame, which may also occur due to the close proximity of the lead frame 32 to the pn-junction active region A. In this way the passivation layer 31 can be said to insulate the n-type substrate from the lead frame 32. Examples of suitable passivation layer 31 materials include silicon nitride or silicon dioxide.

As illustrated in Figures 3a and 3b, the raised portion 33 of the lead frame 32 may be formed by building up the lead frame material, or removal of material so as to define the raised portion 33 of the lead frame 32.

By way of alternative, and as illustrated in Figures 4a and 4b the raised portion 33 of the lead frame 32 may be formed by deforming the lead frame material to create the raised portion 33. As the person skilled in the art of lead frame manufacture will understand the raised portion may be achieved by any appropriate process such as for example stamping, bending and so forth.

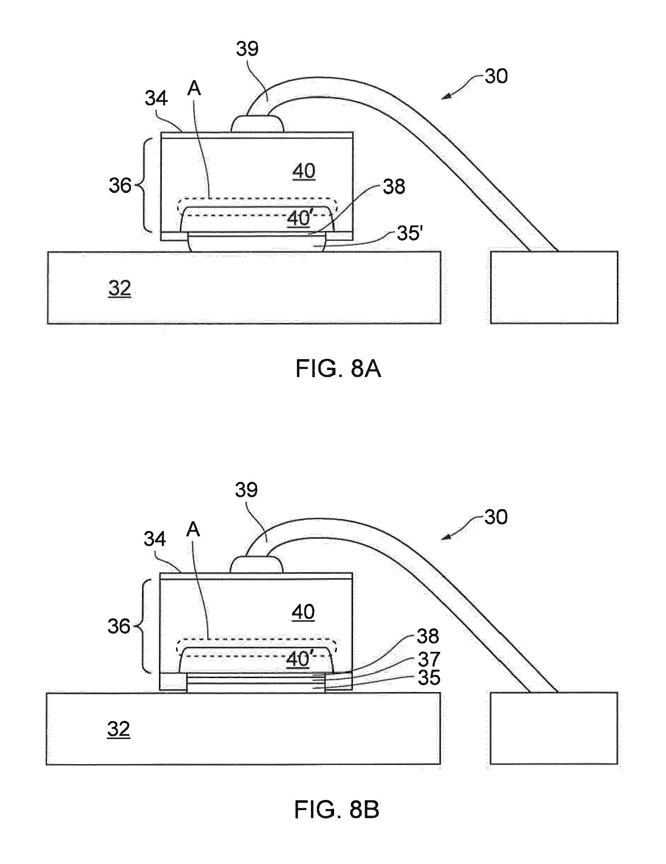

Referring generally to the examples illustrated in Figures 5a to 8b, a planar or flat (that is without the raised portion 33 of the preceding examples) lead frame 32 structure is illustrated. Specifically, referring to figure 5a, the pn-junction 36 includes two step wafer cuts into the side walls 51 of n-type substrate material in order to provide the space needed to receive the sidewall passivation. In addition to the passivation layer 31 being formed on the second surface of the pn-junction 36, the passivation layer 31 is formed into the side wall cuts as to provide electrical insulation of the n-type substrate from the die attach material 35'. In situations where the die attach material 35' is a conductive glue, the side wall passivation is advantageous. During the fabrication process of the device 30, the glue is applied as a liquid and as such it will rise upwardly along the sides of the pn-junction 36 due to the downward pressure of placing the pn-junction 36 on the leadframe 32. Therefore, the sidewall passivation 31 prevents shorting of the n-type substrate to the leadframe 32. Similarly, the example of Figure 5b can also include side wall passivation. However, compared to the example of Figure 4a no side wall cuts are present and the side wall passivation 31 is applied directly to the sides of the pn-junction 36. In Figure 5b the side wall passivation is deposited after crystal separation, for example, by re-using the sidewall passivation deposited during plasma dicing, which avoids the contact of the conductive die attach material 35 and the n-type substrate 40.

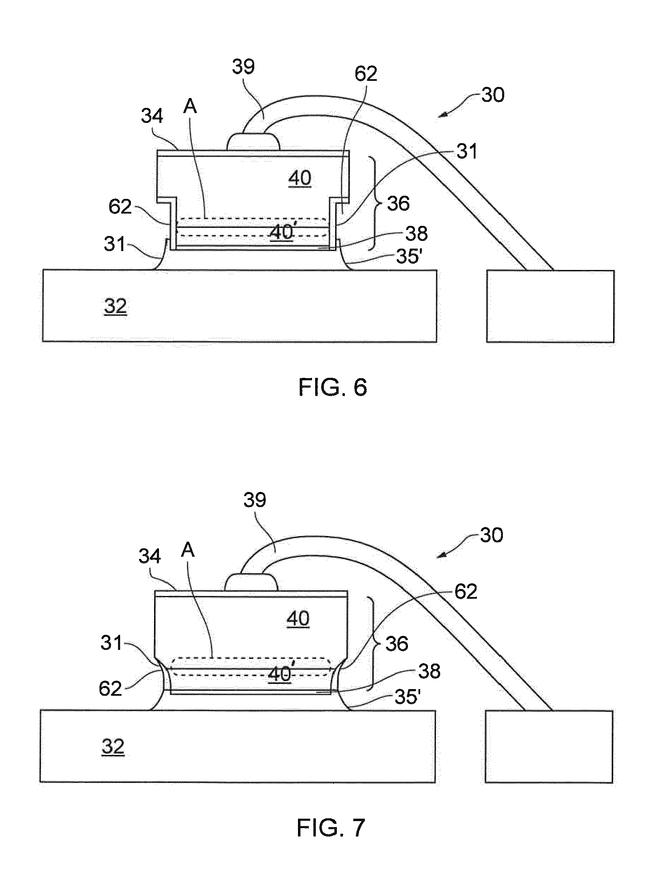

In the examples illustrated in Figure 6 and Figure 7, alternative diode structures are shown. In these examples the pn-junction 36 include side wall trenches 62 which may be formed by either etching or sawing. The passivation 31 is provided in the sidewall trenches to prevent shorting of the n-type substrate to the lead frame

Referring now to Figures 8a and 8b, alternative examples to those of Figures 3a, 3b, 3a and 4c are illustrated. In these examples the die attach material has a footprint smaller than the area of the second surface and as before passivation layers are included to prevent unwanted leakage currents and prevent the possibility of short circuits as discussed above.

In each of the foregoing examples, the contact 34 may be made to the n-type substrate by an appropriate metal contact together with a ball and wire bond 39 to provide external electrical connection. The metal contact 34 may include a diffusion barrier to prevent out diffusion as discussed above. The skilled person will also appreciate that as an alternative to ball and wire bonds, clip-type bond arrangements may be used. In addition in the foregoing examples the device may be encapsulated in a mould compound (not illustrated) which may provide additional thermal mass to conduct heat generated in operation away from the active region A.

The passivation layer 31 described in each of the above examples may be deposited by any appropriate method, for example spin-on glass, thermal or plasma oxides or nitrides.

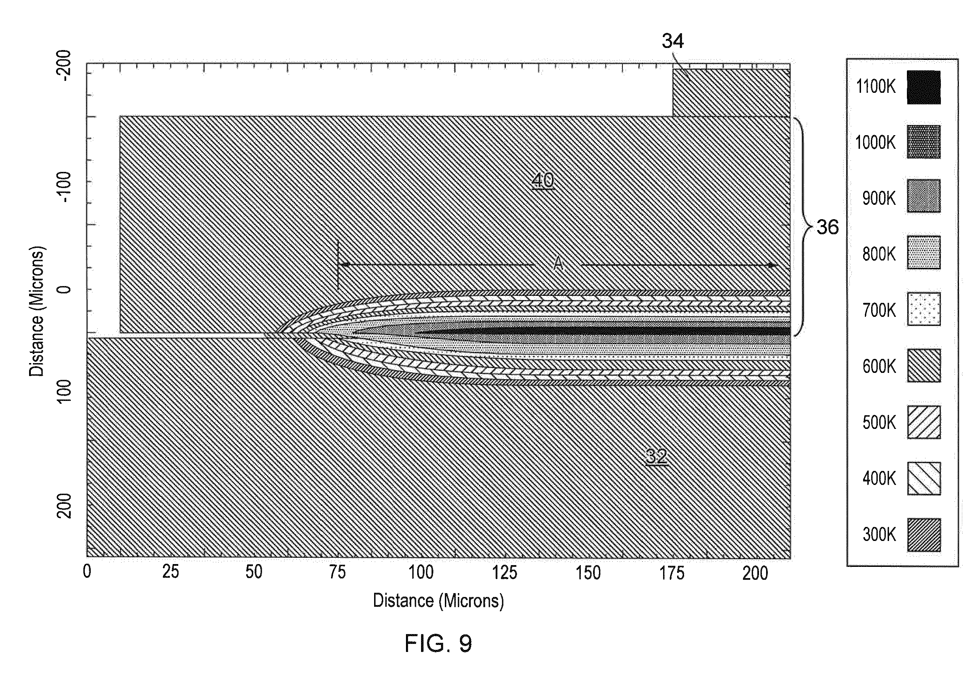

Referring now to Figure 9, this shows an exemplary heat distribution image for the example of Figure 8b. As the skilled person will recognise, due to the proximal arrangement of active area A and lead frame 32, heat generated in the active area A will be dissipated more readily through the lead frame 32 rather than semiconductor substrate and ball and wire bond 39. From a comparison with the prior art arrangement of Figure 2, the skilled person will immediately recognise the benefits of the present arrangement in terms of preventing device heating generated damage to the pn junction device 36.

The process for fabricating surge the protection device 30 is as follows. A semiconductor having the individual pn junction 36 formed thereon is cut into dies. The individual pn junctions 36 are then loaded into a die attach machine on an adhesive film. At die attach machine, the individual pn junctions 36 are picked up by a vacuum needle, flipped upside down and placed on the leadframe 32. Normally the die attach material 35 (either glue, solder or other examples as described above) will be provided on the lead frame 32 prior to placement. The leadframe having the pn-junctions placed thereon are then cured or reflow soldered such that they are ready for wire bonding, where the final electrical external connection is made. The device is then fabricated by moulding using standard mould compound, and finally the devices are trimmed, formed, tested and taped ready for shipment.

Applications of the semiconductor device 30 described in the examples above include surge protection of data interface ports, power supplies associated power management units, together with broad applications in automotive electronics, and telecommunication circuits.

In the foregoing discussion, it will be readily apparent to those skilled in the art the conductivity types of the substrate and impurity region may be reversed. That is the substrate may be p-type and the conductivity of the impurity region may be n-type.

The scope of the present disclosure includes any novel feature or combination of features disclosed therein either explicitly or implicitly or any generalisation thereof irrespective of whether or not it relates to the claimed invention or mitigate against any or all of the problems addressed by the present invention. The applicant hereby gives notice that new claims may be formulated to such features during prosecution of this application or of any such further application derived there from. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A surge protection device comprising:
a lead frame;
a semiconductor substrate formed of a first conductivity type and mounted on said lead frame, said semiconductor substrate comprising first and second opposing surfaces, said second surface having a region of second conductivity type, wherein said region of second conductivity type comprises an electrical contact for contactably mounting said substrate to said lead frame; and
an insulation layer disposed at the second surface and arranged to insulate the region of first conductivity type from the lead frame.

2. The surge protection device of claim 1, where the insulation layer is arranged to prevent electrical contact between the lead frame and the first conductivity type of the semiconductor substrate.

3. The surge protection device of claim 2, wherein the insulation layer is a passivation layer.

4. The surge protection device of claim 3, wherein the passivation layer is silicon oxide or silicon nitride.

5. The surge protection device of any one or more of the preceding claims, wherein the lead frame comprises a raised portion for contacting to the electrical contact.

6. The surge protection of device of claim 1 or claim 2, wherein the semiconductor substrate and the region of second conductivity type are of opposite conductivity types.

7. The surge protection device of claim 1, wherein said region of second conductivity type is contactably mounted to said lead frame by a conductive die attach material.

8. The surge protection device of claim 7, wherein said die attach material is a conductive solder.

9. The surge protection device of claim 7, wherein said die attach material is a conductive glue.

10. The surge protection device of any preceding claim, wherein semiconductor substrate comprises an electrical contact disposed on said first surface.

11. The surge protection device of any one or more of the preceding claims, wherein said regions of first and second conductivity are arranged to form a pn-junction.

12. The surge protection device of claim 11 wherein said pn-junction comprises an active area.

13. The surge protection device of claim 12, wherein active region junction is proximal said lead frame and distal said electrical contact disposed on said second surface.
